(19) Europäisches Patentamt

European Patent Office

Office européen des brevets

(11) EP 0 851 480 B1

(12) EUROPEAN PATENT SPECIFICATION

(45) Date of publication and mention
of the grant of the patent:
**31.10.2001 Bulletin 2001/44**

(51) Int Cl.⁷: **H01L 21/768**, H01L 21/312,
H01L 21/316

(21) Application number: **97112763.4**

(22) Date of filing: **24.07.1997**

(54) **Stress-adjusted insulating film forming method, semiconductor device and method of manufacturing the same**

Herstellungsverfahren für einen isolierenden Film mit eingestellter Spannung, Hableitervorrichtung und Herstellungsverfahren

Procédé de fabrication d'un film isolant à tension réglée, dispositif semiconducteur et son procédé de fabrication

(84) Designated Contracting States:
**DE FR GB NL**

(30) Priority: **25.12.1996 JP 34635196**

(43) Date of publication of application:
**01.07.1998 Bulletin 1998/27**

(73) Proprietors:
• **CANON SALES CO., INC.**
**Minato-ku, Tokyo 108 (JP)**
• **SEMICONDUCTOR PROCESS LABORATORY CO., LTD.**
**Minato-ku, Tokyo 108 (JP)**

(72) Inventors:
• **Nishimoto, Yuhko**
**13-29, Konan 2-chome, Minato-ku, Tokyo (JP)**
• **Maeda, Kazuo**
**13-29, Konan 2-chome, Minato-ku, Tokyo (JP)**

(74) Representative: **Schwabe - Sandmair - Marx**
**Stuntzstrasse 16**
**81677 München (DE)**

(56) References cited:
**EP-A- 0 270 321** **EP-A- 0 307 099**
**EP-A- 0 470 632** **WO-A-91/09422**
**US-A- 5 500 312**

• **PATENT ABSTRACTS OF JAPAN vol. 015, no. 379 (E-1115), 25 September 1991 & JP 03 151637 A (KOWA KURIEITAA:KK), 27 June 1991,**
• **PATENT ABSTRACTS OF JAPAN vol. 095, no. 001, 28 February 1995 & JP 06 291039 A (SANYO ELECTRIC CO LTD), 18 October 1994,**
• **Chemical Vapor Deposition for Microelectronics by A. Sherman, Noyes Publication Co., USA, 1987.**

**Description**

BACKGROUND OF THE INVENTION

1. Field of the Invention

The present invention relates to a stress-adjusted insulating film forming method, according to claim 1. More particularly, it relates to a method of forming stress-adjusted insulating films which are interposed between respective metal interconnection layers upon laminating three or more metal interconnection layers.

2. Description of the Prior Art

In recent years, a multilayered interconnection structure in excess of three-layer has been needed with the progress of high integration density of the semiconductor device. Upper and lower interconnections and adjacent interconnections are insulated with the interlayer insulating films interposed therebetween. However, in such multilayered interconnection structure in excess of three-layer, it is extremely important to bury narrow interconnection regions with leaving no void therein and also to planarize surfaces of such buried interconnection regions.

In the meanwhile, as for various kinds of insulating films, their characteristics have been known for one skilled in the art, as indicated in Table I below.

Table I

| Type of insulating film | Step coverage | Flatness | Film quality |
|---|---|---|---|
| SOG film | ◯ | ◯ | X |
| TEOS/O$_3$thermal CVD film | ◎ | ◯ | ◯ |
| Plasma CVD film | X | X | ◯ |
| High density plasma CVD film | ◎ | X | ◎ |

As one of the interlayer insulating films to be formed between multilayered interconnections in excess of three-layer, a combination of plural insulating films consisting of an insulating film with good film quality and an insulating film with good step coverage may be employed. For instance, a combination of the plasma CVD film and the TEOS/O$_3$thermal CVD film or SOG film is often recommended. In other words, as film forming methods, the plasma CVD method and the thermal CVD method or the coating method may be employed in combination.

In addition, since in general the plasma CVD film has good film quality, it can be used by itself as the interlayer insulating film under the assumption that it is followed by the planarization such as CMP method, etching-back method, etc. Especially, the high density plasma CVD film is suited for such interlayer insulating film application since it has excellent step coverage. In other words, the interlayer insulating film is formed by virtue of ECR, ICP, high density plasma CVD method such as helicon plasma, etc., and then a surface of the interlayer insulating film is planarized by virtue of CMP (Chemical Mechanical Polishing) method or etching-back method.

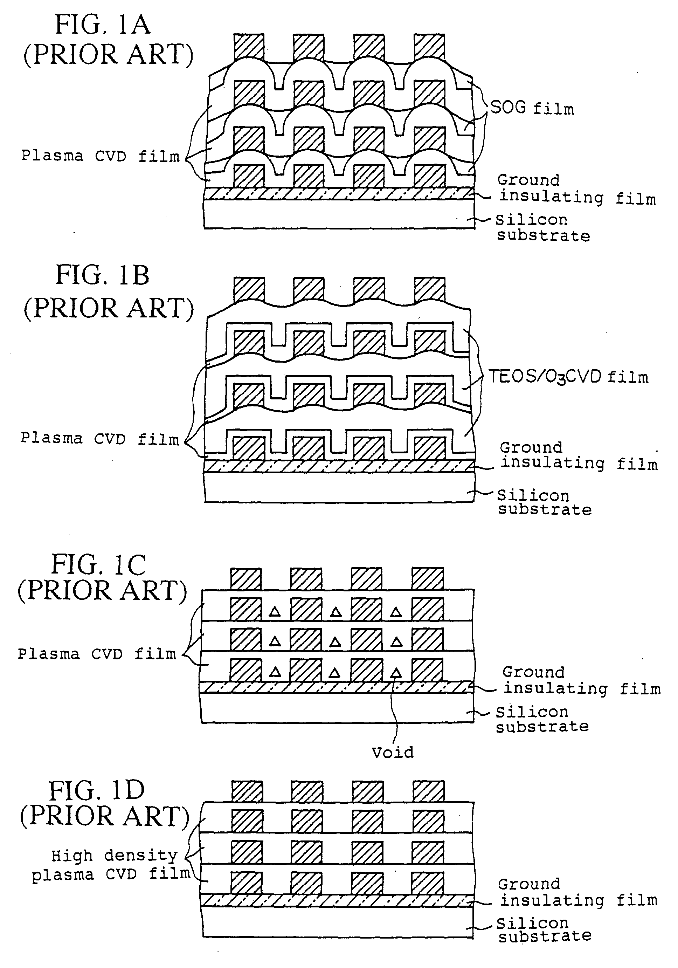

Combinations of the above various insulating films which can be used as the interlayer insulating film may be briefed as follows. Illustrative examples which have been used as the interlayer insulating films between four-layered interconnections are shown in FIGS.1A to 1D.

    1) Plasma CVD film+SOG film (FIG.1A)
    2) Plasma CVD film+TEOS/O$_3$ thermal CVD film (FIG.1B)
    3) Plasma CVD film alone (+CMP) (FIG.1C)
    4) High density plasma CVD film (+CMP) (FIG.1D)

In the case of 3), because the ordinary plasma CVD film is inferior in step coverage, a single plasma CVD film is scarcely used as the interlayer insulating film.

Meanwhile, the above various insulating films which can be used as the interlayer insulating film undergo stress, as indicated in Table II below.

Table II

| Type of insulating film | Stress |
|---|---|
| SOG film | tensile stress |

Table II (continued)

| Type of insulating film | Stress |
|---|---|
| TEOS/$O_3$ thermal CVD film | tensile stress |
| Plasma CVD film | compressive stress |
| High density plasma CVD film | compressive stress |

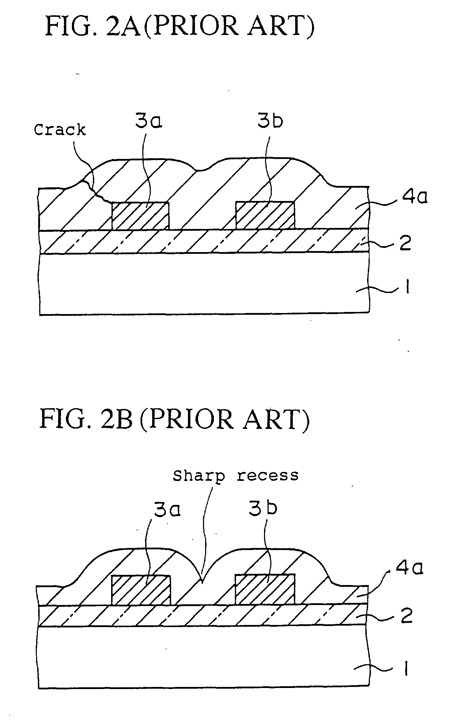

However, no account of stress caused in the overall interlayer insulating film structure has been taken up to this time. As a result, following problems have arisen. That is, in the case of 1) and 2), tensile stress is in general caused in the interlayer insulating film with good step coverage and flatness, i.e., the SOG film or the thermal CVD film (TEOS/$O_3$ thermal CVD film, etc.). In particular, in the case of thermal CVD film, cracks are generated in the film, as shown in FIG.2A, if the film thickness is made thick rather than 1.5 μm. For contrast, if the thickness of the insulating film is made excessively thin, interconnection regions cannot be buried completely by the insulating film to thus generate sharp recesses thereon, as shown in FIG.2B, so that the interconnection conductive film remains in the sharp recesses and flatness of the insulating film is spoiled. Accordingly, there are limitations to employ these insulating films as the single interlayer insulating film. Moreover, it is impossible to employ these insulating films as the interlayer insulating film for the multi-layered interconnections in excess of three layers.

In the case of 3) and 4), extremely large compressive stress is applied as a whole to the insulating films. In order to suppress generation of hillock of the interconnections, etc. and generation of electromigration, it is desired to cover the interconnections with the interlayer insulating film with compressive stress. However, too large compressive stress renders the wafer per se to bend physically, whereby causing problems in manufacturing or problems in device characteristics.

Still further, such a problem has arisen that, if a width of the interconnection is made narrow and a chip size is reduced, stress migration is caused due to stress applied to the interconnection during operation of the device. In other words, if excessively large compressive stress is caused in the insulating film which covers the interconnections such as Al film, etc., the interconnections undergo tensile stress along their grain boundaries to thus lead to breaking of interconnection. The more the layer number of the multi-layered interconnections, the higher the possibility of breaking of interconnection.

EP-A- 0 307 099 and US-A-5500312 disclose multilayer structures with low stress. EP-A-0 470 632 describes plasma irradiation techniques.

## SUMMARY OF THE INVENTION

It is an object of the present invention to provide a stress-adjusted insulating film forming method capable of suppressing electromigration and stress migration in Al interconnections, bowing of wafer, or crack in interlayer insulating film while maintaining step coverage and flatness of the overall interlayer insulating film.

According to the stress-adjusted insulating film forming method of the present invention, an insulating film having a tensile stress and an insulating film having compressive stress are alternately deposited on a substrate to form the stress-adjusted insulating film consisting of the laminated insulating films, as defined in the appending claims.

Therefore, it is possible to adjust the stress of the overall multi-layered insulating films less than a limit stress value ($+3 \times 10^5$ dyne/cm which is determined from the experiment) not to generate the cracks in the insulating films, otherwise it is possible to adjust the stress of the overall multi-layered insulating films within the stress range not to cause the curvature of the wafer, degradation in semiconductor device characteristics, etc.

Further, a stress value of the insulating film can be adjusted by adjusting a thickness of the insulating film to be formed, or by adjusting type of film forming gas or film forming conditions (e.g., frequency of plasma generating power, bias power applied to the substrate, heating temperature of the substrate, type of gas, flow rate of gas, etc.). In this case, stress of the overall interlayer insulating films can be calculated with good precision by making use of a calculation equation whose good precision has been confirmed experimentally.

In a semiconductor device the stress-adjusted insulating film (interlayer insulating film) can be formed to cover the interconnection, based on the above stress-adjusted insulating film forming method.

Thereby, generation of crack in the interlayer insulating film, curvature of the wafer caused by stress, degradation in semiconductor device characteristics, etc. can be prevented by adjusting stress of the interlayer insulating film appropriately. In addition to the above, stress migration and electromigration of the interconnection, e.g., the aluminum interconnection, can also be prevented by adjusting stress of the interlayer insulating film appropriately.

Moreover, while preventing generation of cracks in the interlayer insulating film, migration of the interconnections, etc., the interconnections can be laminated as the multi-layered structure via the interlayer insulating film whose stress is adjusted, whereby resulting in the higher integration density of the semiconductor device.

Other and further objects and features of the present invention will become obvious upon an understanding of the illustrative embodiments about to be described in connection with the accompanying drawings or will be indicated in the appended claims, and various advantages not referred to herein will occur to one skilled in the art upon employing of the invention in practice.

BRIEF DESCRIPTION OF THE DRAWINGS

FIGS.1A to 1D are sectional views each showing an interlayer insulating film laminated structure in the prior art;
FIGS.2A and 2B are sectional views showing problems caused in the laminated structure according to the prior art;
FIGS.3A to 3F are sectional views each showing an interlayer insulating film forming method to illustrate an embodiment of the present invention;
FIG. 4 is a characteristic view showing change in stress due to multilayer stacking of overall interlayer insulating films by virtue of the interlayer insulating film forming method according to the first embodiment of the present invention before and after humidity absorption;
FIGS. 5A to 5E are characteristic views each showing stress adjustment depending upon various film forming conditions in a plasma CVD method according to the first embodiment of the present invention;
FIGS. 6A to 6C are characteristic views each showing stress adjustment depending upon various film forming conditions in a thermal CVD method according to the first embodiment of the present invention;
FIG. 7 is a sectional view showing a semiconductor device and a method of manufacturing the same according to a third embodiment of the present invention; and

DESCRIPTION OF THE PREFERRED EMBODIMENTS

Various embodiments of the present invention will be described with reference to the accompanying drawings. It should be noted that the same or similar reference numerals are applied to the same or similar parts and elements throughout the drawings, and the description of the same or similar parts and elements will be omitted or simplified.

(1) First Embodiment

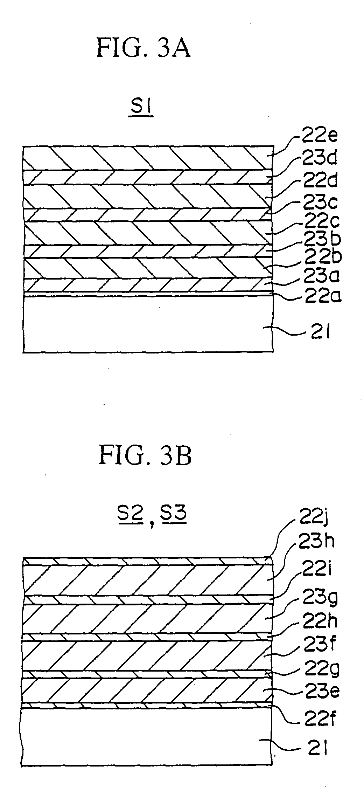

An experiment made to check a stress compensation effect of the present invention will be explained hereunder.
First, a method of forming a sample used in the experiment will be explained. Seven type of samples (S1 to S7) shown in FIGS.3A to 3F have been used. Though locking a step of irradiating the insulating film having tensile stress with a plasma to shift stress in said film do more tensile (step (b)), these examples are in generale suitable to illustrate the lamination of multiple insulating layers having tensile and compressive stress, respectively.

(Formation of sample S1)

A laminated structure of the sample S1 is shown in FIG.3A. Characteristics of respective layers in the sample S1 such as type of insulating film, film thickness, total stress, and generation of crack are indicated in Table III. The insulating film formed by the plasma CVD method will be called a PECVD film (plasma CVD film) hereinafter, and the insulating film formed by the thermal CVD method will be called a THCVD film (thermal CVD film) hereinafter. Further, "total stress" indicated in Table III means stress generated in the overall insulating films after respective insulating films have been laminated, which is calculated according to an amount of bowing generated after respective insulating films have been laminated on a silicon wafer. A calculation method is effected based on a literature, i.e., J. Vac. Scl. Technol. A, Vol.14, No.3, May/Jun 1986, pp.645-649. Similarly, in Tables IV to IX, total stresses have also been calculated according to the same calculation method.

Table III

| Layer (numeral) | Type of insulating film | Film thickness (μm) | Total stress ($\times 10^5$dyne/cm) | Crack generation |
|---|---|---|---|---|
| 1st layer(22a) | PECVD film | 0.2 | -0.38 | none |
| 2nd layer(23a) | THCVD film | 0.5 | +0.53 | none |
| 3rd layer(22b) | PECVD film | 1.0 | -2.0 | none |

Table III   (continued)

| Layer (numeral) | Type of insulating film | Film thickness (µm) | Total stress ($\times 10^5$ dyne/cm) | Crack generation |
|---|---|---|---|---|
| 4th layer(23b) | THCVD film | 1.45 | -1.4 | none |
| 5th layer(22c) | PECVD film | 0.4 | -5.4 | none |
| 6th layer(23c) | THCVD film | 1.45 | -4.5 | none |
| 7th layer(22d) | PECVD film | 0.4 | -9.0 | none |
| 8th layer(23d) | THCVD film | 1.45 | -8.3 | none |
| 9th layer(22e) | PECVD film | 0.4 | $\leqq$-10.7 | none |

In the above Table III, film forming conditions for the plasma CVD film except for a film forming time are common throughout all laminated layers, and they are set forth hereunder.

| Film forming gas (Flow rate sccm) | TMS(15 sccm)+$N_2$O(450 sccm) |
|---|---|
| Pressure | 0.7 Torr |
| Plasma generating power | 150 W |
| Frequency | 13.56 MHz |
| Bias power | 150 W |
| Frequency | 380 kHz |
| Substrate temperature (Film forming temperature) | 330 °C |
| Film forming rate | 150 nm/min |

Under the film forming conditions defined as above, a silicon oxide film having compressive stress of -3.3$\times 10^9$ dyne/cm$^2$ can be formed.

Moreover, film forming conditions of the thermal CVD film except for a film forming time are common in respective layers, which are set forth hereunder.

| Film forming gas (Flow rate sccm) | TEOS(1500 sccm) +$O_3$ 5 % in $O_2$ 7.5 l) |
|---|---|
| Substrate temperature (Film forming temperature) | 400 °C |
| Film forming rate | 87 nm/min |

Under the film forming conditions defined as above, a silicon oxide film having tensile stress of +2.2$\times 10^9$ dyne/cm$^2$ can be formed.

As the organic silane to be included in the film forming gas, TMS (trimethoxysilane: $HSi(OCH_3)_3$) or TEOS (tetraethylorthosilicate: $Si(OC_2H_5)_4$) has been employed in the plasma CVD method and the thermal CVD method. However, such organic silane may be formed of any of alkylsilane or allylsilane (general formula: $R_nSiH_{4-n}$ (n=1 to 4)), alkoxysilane (general formula: $(RO)_nSiH_{4-n}$ (n=1 to 4)), chain siloxane (general formula: $R_nH_{3-n}SiO$ $(R_kH_{2-k}SiO)_mSiH_{3-n}R_n$ (n=1 to 3; k=0 to 2; m$\geqq$0)), derivative of chain siloxane (general formula: $(RO)_nH_{3-n}SiOSiH_{3-n}$ $(OR)_n$ (n=1 to 3)), and ring siloxane (general formula: $(R_kH_{2-k}SiO)_m$ (k=1, 2; m$\geqq$2)) (where R is alkyl group, allyl group, or their derivative).

Still further, ozone ($O_3$ or oxygen ($O_2$) has been employed as the oxygen containing gas. However, the oxygen containing gas may be formed of any of $N_2$O, $NO_2$, CO, $CO_2$, and $H_2$O.

(Formation of sample S2)

A laminated structure of the sample S2 is shown in FIG.3B. Type of insulating film, film thickness, total stress, and generation of crack in respective layers of the sample S2 are indicated in Table IV.

Table IV

| Layer (numeral) | Type of insulating film | Film thickness (µm) | Total stress ($\times 10^5$ dyne/cm) | Crack generation |
|---|---|---|---|---|
| 1st layer(22f) | PECVD film | 0.2 | -0.58 | none |
| 2nd layer(23e) | THCVD film | 1.2 | +2.0 | none |

Table IV (continued)

| Layer (numeral) | Type of insulating film | Film thickness (μm) | Total stress ($\times 10^5$dyne/cm) | Crack generation |
|---|---|---|---|---|
| 3rd layer(22g) | PECVD film | 0.3 | +0.92 | none |
| 4th layer(23f) | THCVD film | 1.5 | +4.0 | none |
| 5th layer(22h) | PECVD film | 0.35 | +2.4 | none |
| 6th layer(23g) | THCVD film | 1.5 | +5.8 | none |
| 7th layer(22i) | PECVD film | 0.35 | +4.0 | generated |
| 8th layer(23h) | THCVD film | 1.5 | +6.7 | remaining |
| 9th layer(22j) | PECVD film | 0.25 | +4.7 | remaining |

In the above Table IV, film forming conditions of the plasma CVD film other than a film forming time are common throughout all laminated layers, and they are set identically to the case where the sample S1 is formed.

Also, film forming conditions of the thermal CVD film other than a film forming time are common in respective layers, and they are set identically to the case where the sample S1 is formed.

(Formation of sample S3)

A laminated structure of the sample S3 is also shown in FIG.3B. Type of insulating film, film thickness, total stress, and generation of crack in respective layers of the sample S3 are indicated in Table V.

Table V

| Layer (numeral) | Type of insulating film | Film thickness (μm) | Total stress ($\times 10^5$dyne/cm) | Crack generation |
|---|---|---|---|---|
| 1st layer(22f) | PECVD film | 0.2 | -0.69 | none |
| 2nd layer(23e) | THCVD film | 1.2 | +2.3 | none |
| 3rd layer(22g) | PECVD film | 0.4 | +0.6 | none |
| 4th layer(23f) | THCVD film | 1.45 | +3.7 | none |
| 5th layer(22h) | PECVD film | 0.4 | +1.5 | none |
| 6th layer(23g) | THCVD film | 1.45 | +5.1 | none |
| 7th layer(22i) | PECVD film | 0.4 | +2.6 | none |
| 8th layer(23h) | THCVD film | 1.45 | +5.3 | none |
| 9th layer(22j) | PECVD film | 0.2 | +3.4 | none |

In the above Table V, film forming conditions of the plasma CVD film except for a film forming time are common throughout all laminated layers, and they are identical to the case where the sample S1 is formed.

Further, film forming conditions of the thermal CVD film except for a film forming time are common in respective layers, and they are identical to the case where the sample S1 is formed.

(Formation of sample S4)

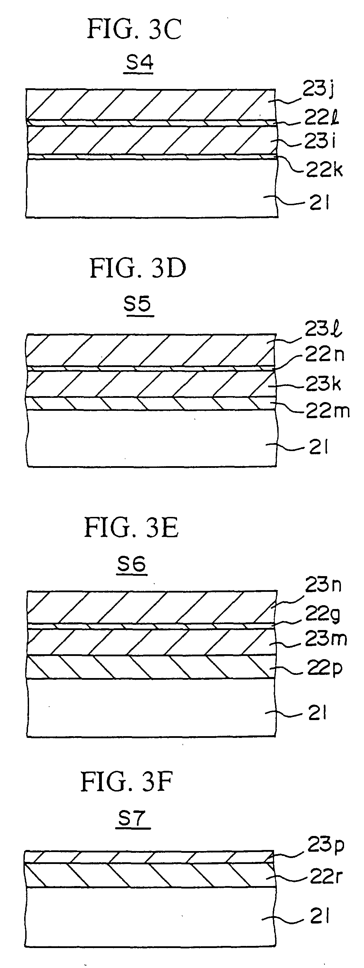

A laminated structure of the sample S4 is shown in FIG.3C. Type of insulating film, film thickness, total stress, and generation of crack in respective layers of the sample S4 are indicated in Table VI.

Table VI

| Layer (numeral) | Type of insulating film | Film thickness (μm) | Total stress ($\times 10^5$dyne/cm) | Crack generation |
|---|---|---|---|---|
| 1st layer(22k) | PECVD film | 0.1 | -0.34 | none |
| 2nd layer(23i) | THCVD film | 1.5 | +3.4 | none |
| 3rd layer(22l) | PECVD film | 0.1 | - | none |
| 4th layer(23j) | THCVD film | 1.6 | +6.8 | generated |

In the above Table VI, film forming conditions of the plasma CVD film other than a film forming time are common throughout all laminated layers, which are identical to the case where the sample S1 is formed.

In addition, film forming conditions of the thermal CVD film other than a film forming time are common in respective layers, which are identical to the case where the sample S1 is formed.

(Formation of sample S5)

A laminated structure of the sample S5 is shown in FIG.3D. Type of insulating film, film thickness, total stress, and generation of crack in respective layers of the sample S5 are indicated in Table VII.

Table VII

| Layer (numeral) | Type of insulating film | Film thickness ($\mu$m) | Total stress ($\times 10^5$dyne/cm) | Crack generation |
|---|---|---|---|---|
| 1st layer(22m) | PECVD film | 0.1 | -0.34 | none |
| 2nd layer(23k) | THCVD film | 1.5 | +3.4 | none |
| 3rd layer(22n) | PECVD film | 0.1 | - | none |
| 4th layer(23l) | THCVD film | 1.6 | +6.8 | none |

In the above Table VII, film forming conditions of the plasma CVD film other than a film forming time are common throughout all laminated layers, which are set to be identical to the case where the sample S1 is formed.

In addition, film forming conditions of the thermal CVD film other than a film forming time are common in respective layers, which are set to be identical to the case where the sample S1 is formed.

(Formation of sample S6)

A laminated structure of the sample S6 is shown in FIG.3E. Type of insulating film, film thickness, total stress, and generation of crack in respective layers of the sample S6 are indicated in Table VIII.

Table VIII

| Layer (numeral) | Type of insulating film | Film thickness ($\mu$m) | Total stress ($\times 10^5$dyne/cm) | Crack generation |
|---|---|---|---|---|
| 1st layer(22p) | PECVD film | 1.1 | -3.2 | none |
| 2nd layer(23m) | THCVD film | 1.2 | -0.65 | none |
| 3rd layer(22q) | PECVD film | 0.1 | - | none |
| 4th layer(23n) | THCVD film | 1.7 | +2.7 | none |

In the above Table VIII, film forming conditions of the plasma CVD film other than a film forming time are common in respective layers, and they are set identically to the case where the sample S1 is formed.

In addition, film forming conditions of the thermal CVD film other than a film forming time are common in respective layers and they are set identically to the case where the sample S1 is formed.

(Formation of sample S7)

A laminated structure of the sample S7 is shown in FIG.3F. Type of insulating film, film thickness, total stress, and generation of crack in respective layers of the sample S7 are indicated in Table IX.

Table IX

| Layer (numeral) | Type of insulating film | Film thickness ($\mu$m) | Total stress ($\times 10^5$dyne/cm) | Crack generation |
|---|---|---|---|---|
| 1st layer(22r) | PECVD film | 1.3 | -3.9 | none |
| 2nd layer(23p) | THCVD film | 0.5 | -0.17 | none |

In the above Table IX, film forming conditions of the plasma CVD film other than a film forming time are common throughout all laminated layers, which are identical to the case where the sample S1 is formed.

In addition, film forming conditions of the thermal CVD film other than a film forming time are common in respective layers, which are identical to the case where the sample S1 is formed.

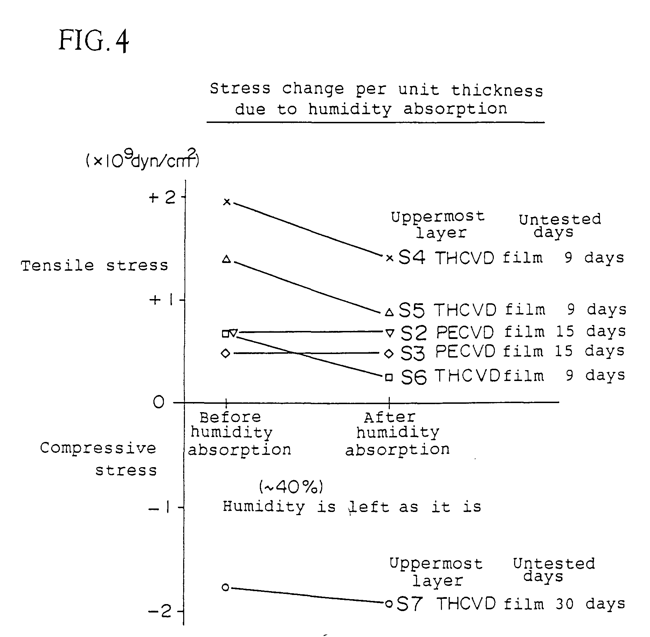

Subsequently, the results are shown in FIGS.4A and 4B when change in stress is summarized in the samples S1 to S3 respectively based on stress values indicated in above Tables III to V after respective insulating layers have been laminated.

From experiments it has been deduced that a stress range not to generate cracks is less than +2 x 10$^5$ dyne/cm if the insulating film is formed on the Al film.

In addition, the results are shown in FIG. 4 when change in stress is investigated in the samples S2 to S7 respectively before and after humidity absorption after the multiple insulating layers are laminated.

FIG. 4 is a characteristic view showing change in stress before and after humidity absorption, wherein an ordinate shows the average stress value ($\times 10^9$ dyne/cm$^2$) caused in the laminated films on a linear scale and an abscissa shows the time interval before and after humidity absorption. In the above experiment, it seems that ambient humidity of the sample has been about 40 % and that humidity absorption has occurred mainly in the thermal CVD films of all the laminated films.

As shown in FIG. 4, it would be evident that variation in stress due to humidity absorption has been large in the samples S4 to S7, in which the uppermost layer is formed of the THCVD film, compared to the samples S2, S3, in which the uppermost layer is formed of the PECVD film. The stress has been shifted towards the compressive stress side due to humidity absorption in the samples S4 to S7. It is desired that the.uppermost layer should be formed of the PECVD film if suppression of variation in stress is needed. Otherwise, from another experiment, it has been confirmed that plasma irradiation after film formation is effective to suppress variation in stress.

It has been found from the above experimental results that stress caused in the overall laminated films can be calculated according to the following equation. That is,

$$\text{Stress in overall laminated films } (\sigma_{\tau}) = \sum_{i=1}^{n} (t_i \times \sigma_i)$$

Where n is the total laminated number, $t_i$ is a thickness of i-th insulating film (cm), and $\sigma_i$ is stress in i-th insulating film (dyne/cm$^2$). As for type of stress of the insulating film, it is assumed that the tensile stress is positive and the compressive stress is negative.

It has been confirmed that, under the assumption that a stress value $\sigma$ of the plasma CVD film is -3$\times 10^9$ dyne/cm$^2$ and a stress value $\sigma$ of the thermal CVD film is +2$\times 10^9$ dyne/cm$^2$, stress values calculated according to the above equation exactly coincide with measured stress values, as indicated in Tables III to IX.

From the samples S2, S4, S5, it is understood that a stress range not to generate the cracks is less than about +3$\times 10^5$ dyne/cm. If stress of the silicon oxide film formed by the thermal CVD method is assumed as 2$\times 10^9$ dyne/cm$^2$, this corresponds to about 1.5 $\mu$m in terms of the thickness of the silicon oxide film formed by the thermal CVD method.

Therefore, if stress of the overall laminated films calculated by the equation is set to a stress limit (+3$\times 10^5$ dyne/cm on an Si film, or +2$\times 10^5$ dyne/cm on an aluminum film) and then thickness and stress of individual insulating films are determined not to exceed this stress limit, cracks in the interlayer insulating films can be prevented.

Depending upon the film forming method and the film forming conditions, stress in the insulating film formed by the plasma CVD method and stress in the insulating film formed by the thermal CVD method can be adjusted as explained hereunder and known to a skilled worker.

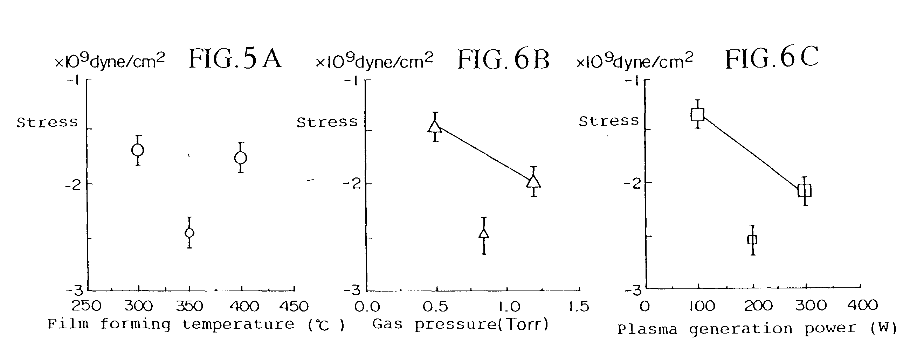

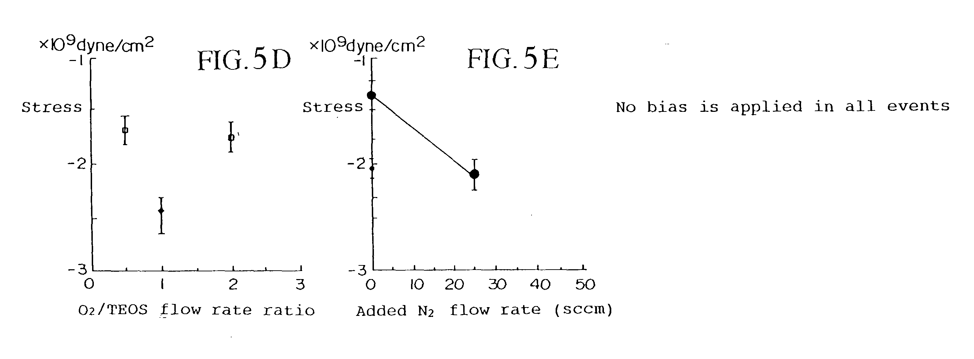

For instance, stress in the insulating film formed by the plasma CVD method can as is known to a skilled worker be adjusted according to type of gas, flow rate of gas, frequency of plasma generating power, bias power applied to the substrate, film forming temperature, etc. Experimental examples are shown in FIGS. 5A to 5E. Although TEOS+O$_2$ system reaction gas has been employed in the experimental examples, stress may be adjusted in a similar manner when TMS+N$_2$O system reaction gas is employed.

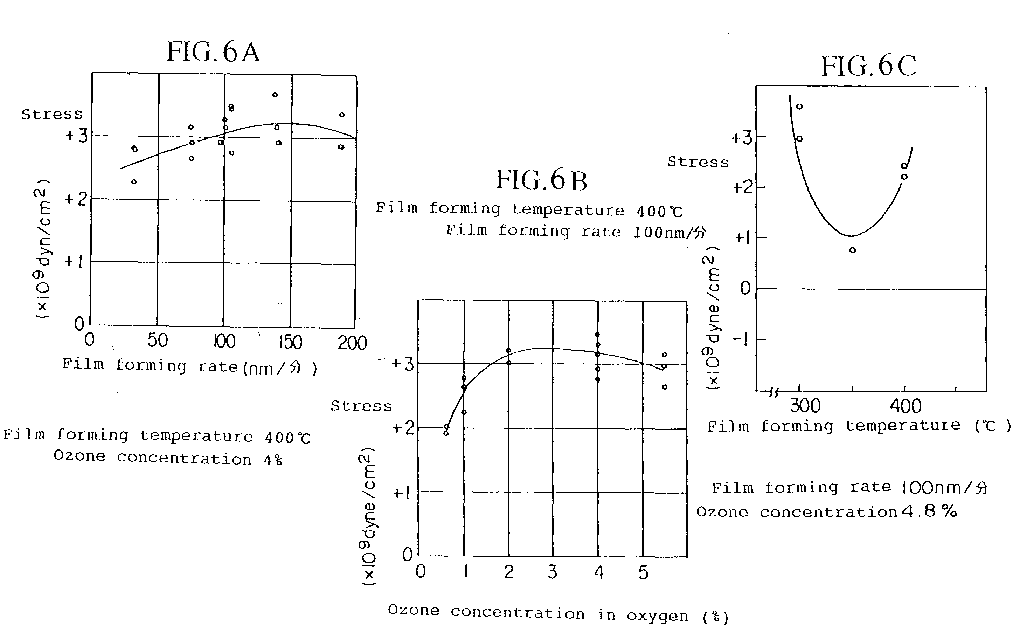

Also stress in the insulating film formed by the thermal CVD method can be adjusted by known methods according to type of gas, flow rate of gas (including ozone concentration in oxygen), film forming temperature, film forming rate, etc. Experimental examples are shown in FIGS. 6A o 6C. The TEDS+O$_3$ reaction gas has been employed as the film forming gas.

However, usually, stress in the insulating film formed by the thermal CVD method is often shifted to the compressive stress side because of humidity absorption after formation. Therefore, if moisture is removed from the insulating film by virtue of plasma irradiation according to the invention stress in the insulating film can be shifted to the tensile stress side. As a result, it is possible to stabilize stress in the insulating film.

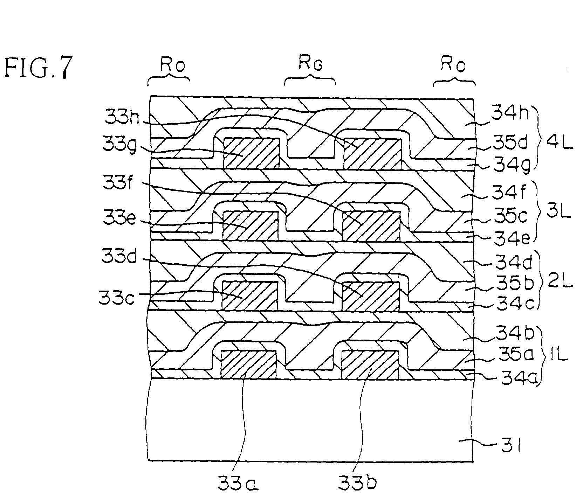

FIG. 7 shows an example of a semiconductor device in which a four-layered interconnections are formed for illustration purposes. The interlayer insulating films formed according to the method of manufacturing the interlayer insulating film of the present invention are interposed respectively between neighboring two interconnections of the four layered interconnections. Film forming gas and film forming conditions used in the plasma CVD method and the thermal CVD method are selected identically to those explained in forming the sample S1 in the first embodiment.

As shown in FIG. 7, interconnections 33a, 33b made of an aluminum film having a thickness of 0.7 μm are formed on a substrate 31.

First, a silicon oxide film 34a of 0.2 μm thickness is formed by virtue of the plasma CVD method to cover the interconnections 33a, 33b.

Then, a silicon oxide film 35a of 0.5 μm thickness is formed on the silicon oxide film 34a by virtue of the thermal CVD method.

In turn, a silicon oxide film 34b of 0.9 μm thickness is formed on the silicon oxide film 35a by virtue of the plasma CVD method.

Subsequently, a surface of the silicon oxide film 34b is planarized by polishing the silicon oxide film 34b by virtue of CMP method (Chemical Mechanical Polishing Method). Thereby, formation of the first-layered interlayer insulating film 1L having a thickness of 1.6 μm to cover the first-layered interconnections 33a, 33b is completed.

Next, second-layered interconnections 33c, 33d made of an aluminum film having a thickness of 0.95 μm are formed on the planarized silicon oxide film 34b.

Then, a second-layered interlayer insulating film 2L having a thickness of 1.85 μm is formed by repeating the above steps. The second-layered interlayer insulating film 2L consists of a silicon oxide film 34c of 0.1 μm thickness formed by the plasma CVD method, a silicon oxide film 35b of 0.45 μm thickness formed by the thermal CVD method, and a silicon oxide film 34d of 1.3 μm thickness formed by the plasma CVD method.

Then, third-layered interconnections 33e, 33f made of an aluminum film having a thickness of 0.95 μm and a third-layered interlayer insulating film 3L having a thickness of 1.85 μm are formed in this order on the second-layered interlayer insulating film 2L. The third-layered interlayer insulating film 3L consists of a silicon oxide film 34e of 0.1 μm thickness formed by the plasma CVD method, a silicon oxide film 35c of 0.45 μm thickness formed by the thermal CVD method, and a silicon oxide film 34f of 1.3 μm thickness formed by the plasma CVD method.

Then, fourth-layered interconnections 33g, 33h made of an aluminum film having a thickness of 0.95 μm and a fourth-layered covering insulating film 4L having a thickness of 1.85 μm are formed in this order on the third-layered interlayer insulating film 3L. The covering insulating film 4L consists of a silicon oxide film 34g of 0.1 μm thickness formed by the plasma CVD method, a silicon oxide film 35d of 0.45 μm thickness formed by the thermal CVD method, and a silicon oxide film 34h of 1.3 μm thickness formed by the plasma CVD method.

With the above, four layered interconnections, three interlayer insulating films 1L to 3L which are interposed respectively between neighboring two interconnections of the four interconnections, and the covering insulating film 4L for covering the fourth layer interconnection have been formed. The preselected interconnections of the interconnections are connected through via holes (not shown) formed in the interlayer insulating films 1L to 3L, into which conductive layers are buried.

If stress of the overall laminated interlayer insulating films, etc. 1L to 4L is set not to exceed the stress limit ($3 \times 10^5$ dyne/cm on the insulating film, $2 \times 10^5$ dyne/cm on the aluminum film), the arbitrary number of interconnections can be laminated without generating the crack in respective interlayer insulating films.

If the above stress limits are restricted narrower, generation of the crack can be suppressed much more, and the curvature of the wafer, degradation in the semiconductor device characteristics, etc. due to stress can also be prevented, and further stress migration or electromigration of the interconnection, e.g., aluminum interconnection, can be prevented.

In addition, if multilayered interconnections are laminated via the stress-adjusted interlayer insulating films while preventing generation of the crack in the interlayer insulating film, etc. and electromigration of the interconnection, etc., the semiconductor device having the high integration density can be accomplished.

As described earlier, according to the interlayer insulating film forming method of the present invention, multiple insulating layers whose total stress is adjusted can be formed by laminating insulating films having different stress mixedly on the substrate.

Accordingly, it is possible to adjust the stress of the overall multilayered insulating films less than the limit stress value not to generate the cracks in the insulating film, otherwise it is possible to adjust the stress of the overall multilayered insulating films within the stress range not to cause the curvature of the wafer, degradation in the semiconductor device characteristics, etc. due to stress.

**Claims**

**1.** A stress-adjusted insulating film forming method, wherein:

an insulating film (23a to 23d) having a tensile stress and an insulating film (22a to 22e) having compressive stress are alternately deposited on a substrate (21) to form said stress-adjusted insulating film consisting of said laminated insulating films (22a, 23a, .., 23d, 22e); said method comprising:

(a) forming an insulating film (23a to 23d) having a tensile stress by reacting a gas mixture including organic silane and oxygen containing gas by virtue of heating;
(b) then irradiating said insulating film (23a to 23d) having a tensile stress with a plasma to shift stress in said insulating film to more tensile;
(c) then forming an insulating film (22a to 22e) having compressive stress on said insulating film (23a to 23d); and
(d) alternating a combination of steps (a) and (b) with step (c) to form a stress-adjusted insulating film consisting of said multiple first and second insulating films (22a, 23a,...,23d, 22e).

2. A stress-adjusted insulating film forming method according to claim 1, wherein stress in said overall stress-adjusted insulating film is adjusted according to the equation:

$$\delta_T \; = \; \sum_{i=1}^{n} \; (t_i \times \delta_i);$$

wherein $\delta_T$ is the stress in the overall stress-adjusted insulating film, $t_i$ is a thickness of the i-th insulating film of said stress-adjusted insulating film, and $\delta_i$ is the stress in the i-th insulating film of said stress-adjusted insulating film, wherein tensile stress is positive and compressive stress is negative.

3. A stress-adjusted insulating film forming method according to claim 2, wherein said stress ($\delta_T$) in the overall stress-adjusted insulating film is tensile stress or compressive stress of less than $+3\times10^5$ dyne/cm.

4. A stress-adjusted insulating film forming method according to one of the preceding claims, wherein said insulating film is a silicon oxide film or a silicon containing insulating film including at least any of phosphorus and boron.

5. A stress-adjusted insulating film forming method according to one of the preceding claims, wherein said gas mixture further includes impurity containing gas.

6. A stress adjusted insulating film forming method according to one of the preceding claims, wherein said insulating film (22a to 22e) having compressive stress is deposited by reacting a gas mixture including organic silane and oxygen containing gas by virtue of a plasma reaction.

7. A stress-adjusted insulating film forming method according to one of the preceding claims, wherein said organic silane is one selected from the group consisting of alkylsilane or allylsilane having the formula: $R_nSiH_{4-n}$ (n=1 to 4), alkoxysilane having the formula: $(RO)_nSiH_{4-n}$ (n=1 to 4), chain siloxane having the formula: $R_nH_{3-n}SiO$ $(R_kH_{2-k}SiO)_mSiH_{3-n}R_n$ (n=1 to 3; k=0 to 2; m$\geqq$0), derivative of chain siloxane having the formula: $(RO)_n$ $H_{3-n}$ $SiOSiH_{3-n}$ $(OR)_n$ (n = 1 to 3), and ring siloxane having the formula: $(R_k$ $H_{2-k}$ $SiO)_m$ (k=1, 2; m $\geqq$ 2) wherein R is alkyl group, allyl group, or their derivative.

8. A stress-adjusted insulating film forming method according to one of the preceding claims, wherein said oxygen containing gas is one selected from the group consisting of ozone ($O_3$), oxygen ($O_2$), $N_2O$, $NO_2$, CO, $CO_2$, and $H_2O$.

9. A stress-adjusted insulating film forming method according to one of the preceding claims, wherein said film forming condition of respective insulating films to adjust stress characteristics of respective insulating films is at least one selected from the group consisting of a frequency of plasma generating power, a bias power applied to said substrate, a film forming temperature, type of gas, and a flow rate of gas.

10. A semiconductor device manufacturing method according to claim 1, wherein:
an insulating film (35a) having a tensile stress and an insulating film (34a, 34b) having compressive stress are alternately deposited covering an interconnection layer (33a, 33b) on a substrate (31) to form a stress-adjusted insulating film.

**11.** A semiconductor device manufacturing method according to claim 1 comprising the steps of:

(a) forming an interconnection layer (33a, 33b) on a substrate (31);
(b) forming a stress-adjusted insulating film (1L) in which an insulating film (35a) having a tensile stress and an insulating film (34a, 34b) having compressive stress are alternately laminated covering said interconnection layer (33a, 33b) on said substrate (31) to form said stress-adjusted insulating film (1L) by:

(i) forming an insulating film (34a) having compressive stress on said interconnection layer,
(ii) forming a insulating film (35a) having a tensile stress by reacting a gas mixture including organic silane and oxygen containing gas by virtue of heating,
(iii) then irradiating said insulating film (35a) having a tensile stress with a plasma to shift stress in said first insulating film (35a) to more tensile,
(iv) then forming an insulating film (34b) having compressive stress on said insulating film (35a) to form said stress-adjusted insulating film (1L) covering said interconnection layer (33a, 33b), and

(c) repeating steps (a) and (b) to laminate alternately said interconnection layers (33a to 33h) and said stress-adjusted insulating films (1L to 4L).

**12.** A semiconductor device manufacturing method according to one of claims 10 or 11, wherein the material of said interconnection layer (33a, 33b) is aluminum.

**Patentansprüche**

**1.** Verfahren zur Bildung einer spannungsangepassten Isolierschicht, in dem eine Isolierschicht (23a bis 23d) mit einer Zugspannung und eine Isolierschicht (22a bis 22e) mit Druckspannung alternierend auf einem Substrat (21) abgeschieden werden, um die spannungsangepasste Isolierschicht, bestehend aus den aufgeschichteten Isolierschichten (22a, 23a, ..., 23d, 22e), zu bilden; das Verfahren umfassend:

a) Bildung einer Isolierschicht (23a bis 23d) mit einer Zugspannung, indem ein Gasgemisch, umfassend organisches Silan und sauerstoffhaltiges Gas, durch Erwärmung zur Umsetzung gebracht wird;
b) dann Bestrahlung der Isolierschicht (23a bis 23d) mit einer Zugspannung mit einem Plasma, um die Spannung in der Isolierschicht in Richtung Zugspannung zu verschieben;
c) dann Bildung einer Isolierschicht (22a bis 22e) mit Druckspannung auf der Isolierschicht (23a bis 23d); und
d) abwechselnd eine Kombination der Schritte a) und b) mit Schritt c), um eine spannungsangepasste Isolierschicht, bestehend aus den mehrfachen ersten und zweiten Isolierschichten (22a, 23a, ..., 23d, 22e), zu bilden.

**2.** Verfahren zur Herstellung einer spannungsangepassten Isolierschicht nach Anspruch 1, in dem die Spannung in der gesamten spannungsangepassten Isolierschicht gemäß der folgenden Gleichung angepasst wird:

$$\delta_T = \sum_{i=1}^{n} (t_i \times \delta_i)$$

wobei $\delta_T$ die Spannung in der gesamten spannungsangepassten Isolierschicht, $t_i$ eine Dicke der i-ten Isolierschicht der spannungsangepassten Isolierschicht und $\delta_i$ die Spannung in der i-ten Isolierschicht der spannungsangepassten Isolierschicht ist, wobei die Zugspannung positiv und die Druckspannung negativ ist.

**3.** Verfahren zur Herstellung einer spannungsangepassten Isolierschicht nach Anspruch 2, in dem die Spannung ($\delta_T$) in der gesamten spannungsangepassten Isolierschicht eine Zugspannung oder eine Druckspannung von weniger als $+3 \times 10^5$ dyne/cm ist.

4. Verfahren zur Herstellung einer spannungsangepassten Isolierschicht nach einem der vorstehenden Ansprüche, in dem die Isolierschicht eine Siliziumoxidschicht oder eine siliziumhaltige Isolierschicht, zumindest eines der Elemente Phosphor und Bor umfassend, ist.

5. Verfahren zur Herstellung einer spannungsangepassten Isolierschicht nach einem der vorstehenden Ansprüche, in dem das Gasgemisch weiterhin ein Verunreinigungen enthaltendes Gas umfasst.

6. Verfahren zur Herstellung einer spannungsangepassten Isolierschicht nach einem der vorstehenden Ansprüche, in dem die Isolierschicht (22a bis 22e) mit Druckspannung abgeschieden wird, indem ein Gasgemisch, umfassend organisches Silan und sauerstoffhaltiges Gas, durch eine Plasmareaktion zur Umsetzung gebracht wird.

7. Verfahren zur Herstellung einer spannungsangepassten Isolierschicht nach einem der vorstehenden Ansprüche, in dem das organische Silan ausgewählt wird aus der Gruppe bestehend aus Alkylsilan oder Allylsilan der Formel: $R_nSiH_{4-n}$ (n = 1 bis 4), Alkoxysilan der Formel: $(RO)_nSiH_{4-n}$ (n = 1 bis 4), Kettensiloxan der Formel: $R_nH_{3-n}SiO$ $(R_kH_{2-k}SiO)_mSiH_{3-n}R_n$ (n = 1 bis 3; k = 0 bis 2; m $\geq$ 0), Derivat eines Kettensiloxans, folgende Formel aufweisend: $(RO)_nH_{3-n}SiOSiH_{3-n}(OR)_n$ (n = 1 bis 3), und Ringsiloxan der Formel: $(R_kH_{2-k}SiO)_m$ (k = 1, 2; m $\geq$ 2), wobei R eine Alkylgruppe, Allylgruppe oder ein Derivat davon ist.

8. Verfahren zur Herstellung einer spannungsangepassten Isolierschicht nach einem der vorstehenden Ansprüche, in dem das sauerstoffhaltige Gas ausgewählt wird aus der Gruppe bestehend aus Ozon ($O_3$), Sauerstoff ($O_2$), $N_2O$, $NO_2$, CO, $CO_2$ und $H_2O$.

9. Verfahren zur Herstellung einer spannungsangepassten Isolierschicht nach einem der vorstehenden Ansprüche, in dem die Bedingung für die Schichtbildung entsprechender Isolierschichten zur Anpassung der Spannungseigenschaften entsprechender Isolierschichten zumindest eine ist, die aus der Gruppe ausgewählt wird bestehend aus einer Frequenz einer Plasma erzeugenden Leistung, einer Gittervorspannungsleistung, angelegt an das Substrat, einer schichtbildenden Temperatur, Art des Gases und einer Strömungsgeschwindigkeit eines Gases.

10. Verfahren zur Herstellung einer Halbleitervorrichtung nach Anspruch 1, in dem eine Isolierschicht (35a) mit einer Zugspannung und eine Isolierschicht (34a, 34b) mit Druckspannung alternierend abgeschieden werden, dabei eine Zwischenschaltungsschicht (33a, 33b) auf einem Substrat (31) bedeckend, um eine spannungsangepasste Isolierschicht zu bilden.

11. Verfahren zur Herstellung einer Halbleitervorrichtung nach Anspruch 1, umfassend folgende Schritte:

   a) Bildung einer Zwischenschaltungsschicht (33a, 33b) auf einem Substrat (31);
   b) Bildung einer spannungsangepassten Isolierschicht (1L), in der eine Isolierschicht (35a) mit einer Zugspannung und eine Isolierschicht (34a, 34b) mit Druckspannung alternierend aufgeschichtet werden, dabei die Zwischenschaltungsschicht (33a, 33b) auf dem Substrat (31) bedeckend, um die spannungsangepasste Isolierschicht (1L) zu bilden durch:

   (i) Bildung einer Isolierschicht (34a) mit Druckspannung auf der Zwischenschaltungsschicht,
   (ii) Bildung einer Isolierschicht (35a) mit einer Zugspannung, indem ein Gasgemisch, umfassend organisches Silan und sauerstoffhaltiges Gas, durch Erwärmung zur Umsetzung gebracht wird,
   (iii) dann Bestrahlung der Isolierschicht (35a) mit einer Zugspannung mit einem Plasma, um die Spannung in der ersten Isolierschicht (35a) in Richtung Zugspannung zu verschieben,
   (iv) dann Bildung einer Isolierschicht (34b) mit Druckspannung auf der Isolierschicht (35a), um die spannungsangepasste Isolierschicht (1L) zu bilden, welche die Zwischenschaltungsschicht (33a, 33b) bedeckt, und

   c) Widerholung der Schritte a) und b), um die Zwischenschaltungsschichten (33a bis 33h) und die spannungsangepassten Isolierschichten (1L bis 4L) alternierend aufzuschichten.

12. Verfahren zur Herstellung einer Halbleitervorrichtung nach einem der Ansprüche 10 oder 11, in dem das Material der Zwischenschaltungsschicht (33a, 33b) Aluminium ist.

**Revendications**

1.  Procédé de formation d'un film isolant à contrainte ajustée, dans lequel :

    un film isolant (23a à 23d) ayant une contrainte de traction et un film isolant (22a à 22e) ayant une contrainte de compression sont déposés de manière alternée sur un substrat (21) pour former ledit film isolant à contrainte ajustée constitué desdits films isolants stratifiés (22a, 23a, ..., 23d, 22e), ledit procédé comportant les étapes consistant à :

    (a) former un film isolant (23a à 23d) ayant une contrainte de traction en faisant réagir un mélange gazeux incluant du silane organique et un gaz contenant de l'oxygène en vertu d'un chauffage,
    (b) irradier ensuite ledit film isolant (23a à 23d) ayant une contrainte de traction à l'aide d'un plasma pour changer la contrainte dans ledit film isolant jusqu'à une traction plus importante,
    (c) former ensuite un film isolant (22a à 22e) ayant une contrainte de compression sur ledit film isolant (23a à 23d), et
    (d) alterner une combinaison d'étapes (a) et (b) avec l'étape (c) pour former un film isolant à contrainte ajustée constitué desdits multiples premiers et seconds films isolants (22a, 23a, ..., 23d, 22e).

2.  Procédé de formation d'un film isolant à contrainte ajustée selon la revendication 1, dans lequel la contrainte dans l'ensemble dudit film isolant à contrainte ajustée est ajustée conformément à l'équation suivante :

$$\delta_T = \sum_{i=1}^{n} (t_i \times \delta_i) \ ;$$

où $\delta_T$ est la contrainte dans l'ensemble du film isolant à contrainte ajustée, $t_i$ est une épaisseur du i-ième film isolant dudit film isolant à contrainte ajustée, et $\delta_i$ est la contrainte dans le i-ième film isolant dudit film isolant à contrainte ajustée, la contrainte de traction étant positive et la contrainte de compression étant négative.

3.  Procédé de formation d'un film isolant à contrainte ajustée selon la revendication 2, dans lequel ladite contrainte ($\delta_T$) dans l'ensemble du film isolant à contrainte ajustée est une contrainte de traction ou une contrainte de compression de moins de + 3 x $10^5$ dyne/cm.

4.  Procédé de formation d'un film isolant à contrainte ajustée selon l'une quelconque des revendications précédentes, dans lequel ledit film isolant est un film d'oxyde de silicium ou un film isolant contenant du silicium incluant au moins un quelconque élément parmi du phosphore et du bore.

5.  Procédé de formation d'un film isolant à contrainte ajustée selon l'une quelconque des revendications précédentes, dans lequel ledit mélange gazeux comporte de plus un gaz contenant une impureté.

6.  Procédé de formation d'un film isolant à contrainte ajustée selon l'une quelconque des revendications précédentes, dans lequel ledit film isolant (22a à 22e) ayant une contrainte de compression est déposé en faisant réagir un mélange gazeux incluant du silane organique et un gaz contenant de l'oxygène en vertu d'une réaction au plasma.

7.  Procédé de formation d'un film isolant à contrainte ajustée selon l'une quelconque des revendications précédentes, dans lequel ledit silane organique est sélectionné parmi le groupe constitué par un alkylsilane ou allylsilane ayant la formule : $R_nSiH_{4-n}$ (n = 1 à 4), un alcoxysilane ayant la formule : $(RO)_nSiH_{4-n}$ (n = 1 à 4), une chaîne siloxane ayant la formule : $R_nH_{3-n}SiO (R_kH_{2-k}SiO)_mSiH_{3-n}R_n$ (n = 1 à 3 ; k = 0 à 2 ; m ≥ 0), un dérivé d'une chaîne siloxane ayant la formule : $(RO)_nH_{3-n}SiOSiH_{3-n}(OR)_n$ (n = 1 à 3), et un siloxane cyclique ayant la formule : $(R_k H_{2-k} SiO)_m$ (k = 1, 2 ; m ≥ 2) où R est un groupe alkyle, un groupe allyle, ou un dérivé de ceux-ci.

8.  Procédé de formation d'un film isolant à contrainte ajustée selon l'une quelconque des revendications précédentes, dans lequel ledit gaz contenant de l'oxygène est un gaz sélectionné parmi le groupe constitué d'ozone ($O_3$), d'oxygène ($O_2$), $N_2O$, $NO_2$, CO, $CO_2$, et $H_2O$.

9.  Procédé de formation d'un film isolant à contrainte ajustée selon l'une quelconque des revendications précédentes, dans lequel ladite condition de formation de film de films isolants respectifs pour ajuster des caractéristiques de contrainte de films isolants respectifs est au moins une condition sélectionnée parmi le groupe constitué d'une fréquence de puissance de génération de plasma, d'une puissance de polarisation appliquée audit substrat, d'une température de formation de film, d'un type de gaz, et d'un débit de gaz.

**10.** Procédé de fabrication d'un dispositif à semi-conducteurs selon la revendication 1, dans lequel :
un film isolant (35a) ayant une contrainte de traction et un film isolant (34a, 34b) ayant une contrainte de compression sont déposés de manière alternée en recouvrant une couche d'interconnexion (33a, 33b) sur un substrat (31) pour former un film isolant à contrainte ajustée.

**11.** Procédé de fabrication d'un dispositif à semi-conducteurs selon la revendication 1, comportant les étapes consistant à :

(a) former une couche d'interconnexion (33a, 33b) sur un substrat (31),
(b) former un film isolant à contrainte ajustée (1L) dans lequel un film isolant (35a) ayant une contrainte de traction et un film isolant (34a, 34b) ayant une contrainte de compression sont stratifiés de manière alternée en recouvrant ladite couche d'interconnexion (33a, 33b) sur ledit substrat (31) pour former ledit film isolant à contrainte ajustée (1L) à l'aide des étapes consistant à :

(i) former un film isolant (34a) ayant une contrainte de compression sur ladite couche d'interconnexion,
(ii) former un film isolant (35a) ayant une contrainte de traction en faisant réagir un mélange gazeux incluant du silane organique et un gaz contenant de l'oxygène en vertu d'un chauffage,
(iii) irradier alors ledit film isolant (35a) ayant une contrainte de traction à l'aide d'un plasma pour changer la contrainte dans ledit premier film isolant (35a) jusqu'à une traction plus importante ;
(iv) former alors un film isolant (34b) ayant une force de compression sur ledit film isolant (35a) pour former ledit film isolant à contrainte ajustée (1L) recouvrant ladite couche d'interconnexion (33a, 33b), et

(c) répéter les étapes (a) et (b) pour stratifier de manière alternée lesdites couches d'interconnexion (33a à 33h) et lesdits films isolants à contrainte ajustée (1L à 4L).

**12.** Procédé de fabrication d'un dispositif à semi-conducteurs selon l'une quelconque des revendications 10 ou 11, dans lequel le matériau de ladite couche d'interconnexion (33a, 33b) est de l'aluminium.

FIG. 1A
(PRIOR ART)

SOG film

Plasma CVD film

Ground
insulating film

Silicon
substrate

FIG. 1B
(PRIOR ART)

TEOS/O$_3$CVD film

Plasma CVD film

Ground
insulating film

Silicon
substrate

FIG. 1C
(PRIOR ART)

Plasma CVD film

Ground
insulating film

Silicon
substrate

Void

FIG. 1D
(PRIOR ART)

High density
plasma CVD film

Ground
insulating film

Silicon
substrate

## FIG. 2A(PRIOR ART)

Crack   3a   3b

4a

2

1

## FIG. 2B (PRIOR ART)

Sharp recess

3a   3b

4a

2

1

FIG. 3A

S1

22e
23d
22d
23c
22c
23b
22b
23a
22a

21

FIG. 3B

S2 , S3

22j
23h
22i
23g
22h
23f
22g
23e
22f

21

## FIG. 3C

S4

23j
22l
23i
22k
21

## FIG. 3D

S5

23l
22n
23k
22m
21

## FIG. 3E

S6

23n
22g
23m
22p
21

## FIG. 3F

S7

23p
22r
21

# FIG.4

Stress change per unit thickness
due to humidity absorption

$(\times 10^9 dyn/cm^2)$

Tensile stress

$+2$

$+1$

Uppermost   Untested
layer        days

× S4 THCVD film  9 days

△ S5 THCVD film  9 days

▽ S2 PECVD film 15 days
◇ S3 PECVD film 15 days
□ S6 THCVD film  9 days

$0$

Before          After
humidity        humidity
absorption      absorption

Compressive
stress

$(\sim 40\%)$
Humidity is left as it is

$-1$

Uppermost   Untested
layer        days

○ S7 THCVD film 30 days

$-2$

FIG.5A — $\times 10^9 \text{dyne/cm}^2$

Stress vs Film forming temperature (℃)

FIG.6B — $\times 10^9 \text{dyne/cm}^2$

Stress vs Gas pressure(Torr)

FIG.6C — $\times 10^9 \text{dyne/cm}^2$

Stress vs Plasma generation power (W)

EP 0 851 480 B1

FIG.5D

×$10^9$dyne/cm$^2$

Stress

$O_2$/TEOS flow rate ratio

FIG.5E

×$10^9$dyne/cm$^2$

Stress

Added $N_2$ flow rate (sccm)

No bias is applied in all events

EP 0 851 480 B1

## FIG.6A

Stress

$(\times 10^9 \mathrm{dyn/cm^2})$

Film forming rate (nm/分)

Film forming temperature 400℃
Ozone concentration 4%

## FIG.6B

Film forming temperature 400℃
Film forming rate 100nm/分

Stress

$(\times 10^9 \mathrm{dyne/cm^2})$

Ozone concentration in oxygen (%)

## FIG.6C

Stress

$(\times 10^9 \mathrm{dyne/cm^2})$

Film forming temperature (℃)

Film forming rate 100nm/分
Ozone concentration 4.8%

EP 0 851 480 B1

FIG.7

R₀          R_G          R₀

33h                                      34h ⎫
33g                                      35d ⎬ 4L
                                         34g ⎭

33f                                      34f ⎫
33e                                      35c ⎬ 3L
                                         34e ⎭

33d                                      34d ⎫
33c                                      35b ⎬ 2L
                                         34c ⎭

                                         34b ⎫
                                         35a ⎬ IL
                                         34a ⎭

31

33a          33b